Europäisches Patentamt

European Patent Office

Office européen des brevets

(11) Veröffentlichungsnummer: **0 638 812 A2**

# (12) EUROPÄISCHE PATENTANMELDUNG

(21) Anmeldenummer: **94112525.4**

(51) Int. Cl.6: **G01R 31/06**

(22) Anmeldetag: **10.08.94**

(30) Priorität: **11.08.93 DE 4326942**

(43) Veröffentlichungstag der Anmeldung:
**15.02.95 Patentblatt 95/07**

(84) Benannte Vertragsstaaten:
**AT BE CH DE ES FR GB IT LI LU NL SE**

(71) Anmelder: **VEBA KRAFTWERKE RUHR
AKTIENGESELLSCHAFT
Bergmannsglückstrasse 41-43
D-45896 Gelsenkirchen (DE)**

(72) Erfinder: **Verkamp, Manfred, Dipl. Ing.**

Wupperweg 36
D-46286 Dorsten (DE)
Erfinder: **Ronsdorf, Dieter, Dipl. Ing.**
Heyenbergstr. 12
D-44799 Bochum (DE)
Erfinder: **Mahr, Christian, Dipl. Ing.**
Bogenstr. 23a
D-45894 Gelsenkirchen (DE)

(74) Vertreter: **Cohausz & Florack
Patentanwälte
Kanzlerstrasse 8a
D-40472 Düsseldorf (DE)**

(54) **Einrichtung zur Überwachung eines Auslösemittels eines elektrischen Betriebsmittels auf elektrische Defekte.**

(57) Die Erfindung betrifft eine Vorrichtung und ein Verfahren zur Überwachung von Auslösekreisen elektrischer Betriebsmittel, insbesondere von Leistungsschaltern in Mittel- oder Hochspannungsschaltanlagen auf elektrische Defekte, dessen Auslösespule 2 über eine Zuleitung 5 mit einem entfernt angeordneten Auslösekontakt 3 verbunden ist. Um eine genaue Fehleranalyse zu ermöglichen, ist erfindungsgemäß vorgesehen, daß die Sprungantwort des Auslösekreises 5,1,2 auf einen an den Leitungseingang E angelegten Spannungssprung detektiert wird, daß der zeitliche Verlauf der Sprungantwort in zeitdiskrete Bereiche aufgeteilt wird und daß bereichsbezogen ein Vergleich des Verlaufs der Sprungantwort mit der beim fehlerfreien Betrieb ermittelten Sprungantwort erfolgt.

Fig. 2

Die Erfindung betrifft eine Einrichtung zur Überwachung eines Auslösekreises eines elektrischen Betriebsmittels, insbesondere eines Leistungsschalters in Mittel- oder Hochspannungsschaltanlagen, dessen Auslösespule über eine Zuleitung mit entfernt angeordneten Auslösekontakten verbunden ist, auf elektrische Defekte.

Unter einem Betriebsmittel ist ein Bauteil zu verstehen, welches als Bestandteil eines Schutzsystems die Aufgabe hat, defekte oder gefährdete Aggregate (Leitungen, Transformatoren, Motoren) von der Stromversorgung abzutrennen. Beim Defekt eines Aggregats fällt üblicherweise das gesamte Schutzsystem bestehend aus Meßwandlern, Schutzeinrichtungen, Auslösewege mit Auslösespule und Leistungsschaltern aus.

Herkömmliche Leistungschalter in Mittel- oder Hochspannungsschaltanlagen werden über Magnetspulen ausgelöst, die in Arbeitsstromschaltung ein- oder zweipolig geschaltet werden. Die Schutzeinrichtung der Schaltanlage aktiviert dabei die Auslösespule durch Schließen der Auslösekontakte, die mit der Auslösespule üblicherweise über eine längere Zuleitung verbunden sind. Zwar werden solche Leistungsschalter in bestimmten Zeitabständen gewartet, jedoch können innerhalb der Wartungsintervalle Fehler auftreten, so daß diese nicht erkannt werden ebenso wie solche Fehler, die im Rahmen der üblichen Wartung nicht geprüft werden.

Insbesondere treten als Fehler auf: Widerstandserhöhungen, Unterbrechung bzw. Kurzschluß in den Zuleitungen, Unterbrechungen durch fehlerhafte Abschaltkontakte, Windungsschlüsse bzw. Windungsunterbrechungen in der Auslösespule, Defekte in der Schutzbeschaltung für die Auslösespule sowie Komplettausfall der Spannungsversorgung für den Auslösekontakt.

Aus der DE 39 22 900 ist eine Überwachungseinrichtung für einen Elektromagneten bekannt. Hierbei wird der Elektromagnet mit einem Spannungstestimpuls beaufschlagt, dessen Pulsbreite so gemessen ist, daß der Elektromagnet selbst nicht betätigt wird. An einer Entkopplungsdiode wird die Abschaltspannung des Elektromagneten abgegriffen, über einen Spannungsteiler gemessen und über weitere Bauelemente in einen Rechteckimpuls umgewandelt. Aus einem Vergleich der Pulsbreite des gemessenen Wertes mit einem Sollwert wird erkannt, wenn der Magnet einen Fehler aufweist.

Der Erfindung liegt die Aufgabe zugrunde, eine Einrichtung der eingangs genannten Art dahingehend zu verbessern, daß eine genaue Überwachung des Auslösekreises auf die oben genannten Fehler möglich ist.

Diese Aufgabe wird erfindungsgemäß dadurch gelöst, daß parallel zu den Eingangsklemmen der Zuleitung eine Reihenschaltung aus einem einen Spannungssprung erzeugenden Generator und einer Meßimpedanz angeordnet ist und daß Mittel zur Erfassung des zeitlichen Verlaufs des Spannungsabfalls an der Meßimpedanz sowie für dessen Unterteilung in zeitdiskrete Bereiche und für dessen bereichsbezogene Analyse vorgesehen sind.

Das mittels dieser Einrichtung durchgeführte Verfahren sieht als wesentliche Maßnahme zur ständigen Fehlerüberwachung vor, daß die Sprungantwort des Auslösekreises auf einen an den Leitungeingang angelegten Spannungssprung detektiert wird. Aus der Sprungantwort, d.h. dem zeitlichen Verlauf der an der Meßimpedanz abfallenden Spannung, lassen sich Aussagen über die Funktion bzw. Fehlfunktion von typischen Bestandteilen des Auslösekreises erfassen, insbesondere dadurch, daß die gemessenen zeitlichen Verläufe der Sprungantworten des Auslösekreises mit der Sprungantwort des fehlerfreien Betriebes verglichen werden. Dadurch, daß die Analyse der Sprungantwort ständig erfolgt, können Fehler schnell und sicher identifiziert werden. Unterschiedliche zeitliche Bereiche des Sprungantwortprofils ermöglichen eine Trennung der möglichen auftretenden Fehlerarten. So treten kapazitiv bedingte Fehler, beispielsweise durch Änderungen der Leitungkapazität, im ersten Zeitbereich der Sprungantwort auf, während durch Ohm'sche Auswirkungen, beispielsweise Widerstanderhöhungen in den Zuleitungen, bedingte Fehler sich aus der Analyse des Endbreichs des Spannungszeitprofils erkennen lassen.

Die erfindungsgemäße Einrichtung läßt sich an elektrischen Betriebsmitteln, insbesondere Leistungsschaltern in Mittel- oder Hochspannungsschaltanlagen verschiedener Hersteller universell anwenden.

Bei der Auslegung der Einrichtung wurden die für die Schutztechnik geltenden VDE/IEC-Bestimmungen, insbesondere VDE/IEC 0435, berücksichtigt.

Zur Ankopplung der Einrichtung an die Gleichstromversorgung und die Auslösekreise wird durch eintsprechende Maßnahmen innerhalb des Schaltungsaufbaues sichergestellt, daß Fehlfunktionen der Einrichtung nicht zu Fehlauslösungen des Leistungsschalters führen.

Dadurch, daß die Auslösespule des Leistungsschalters in Reihe mit einem Abschaltkontakt am Zuleitungsausgang angeschlossen ist, kann die erfindungsgemäße Fehleranalyseeinrichtung auch für solche Leistungsschalter eingesetzt werden, bei denen zur Vermeidung der Überlastung der Auslösespule nach dem Abschalten des Leistungsschalters der Abschaltkontakt öffnet und den Stromkreis unterbricht. Unterbrechungen durch fehlerhafte Abschaltkontakte können somit mit in den Fehlerüberwachungsprozeß einbezogen werden.

Eine besondere Ausführungsform der Erfindung sieht vor, daß die Meßschaltung Mittel zu ihrer Selbstadaptierung an den zu überwachenden Auslösekreis aufweist derart, daß die Mittel die Sprungantwort und die elektrischen Kenngrößen des fehlerfreien Auslösekreises erfassen und hieraus berechnete Referenzwerte abspeichern, aus denen Amplitude und Periodendauer des Meßimpulses des Pulsgenerators ermittelt werden. Hierdurch wird eine automatische Anpassung der Einrichtung an den zu überwachenden Auslösekreis erreicht, wodurch die Bedienbarkeit wesentlich vereinfacht wird.

Weitere bevorzugte Ausführungsformen sind in weiteren Unteransprüchen charakterisiert.

Die Erfindung wird im folgenden anhand einer ein Ausführungsbeispiel zeigenden Zeichnung näher erläutert:
Dabei zeigen:

Fig. 1     einen Auslösekreis für einen als elektrisches Betriebsmittel dienenden Leistungsschalter, wie er aus dem Stand der Technik bekannt ist,

Fig. 2     eine erfindungsgemäße Einrichtung zur Überwachung eines Leistungsschalters,

Fig, 3     ein Impulsdiagramm für den vom Pulsgenerator gelieferten Ausgangsimpuls,

Fig.4 - Fig. 7     Sprungantworten des Auslösekreises bei unterschiedlichen Schutzbeschaltungen der Auslösespule.

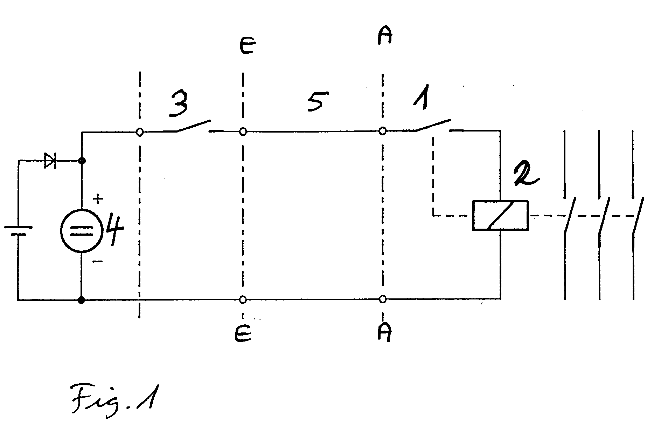

Fig. 1 zeigt einen Auslösekreis für einen Leistungsschalter, von dem die Erfindung ausgeht. Die Auslösespule 2 des Leistungsschalters wird betätigt über einen Auslösekontakt 3, der entfernt vom Ort des Leistungsschalters angeordnet ist. Über eine Zuleitung 5, deren Eingangsklemmen E und Ausgangsklemmen A in Fig. 1 ebenfals dargestellt sind, sind Auslösekontakt 3 und Auslösespule 2 verbunden.

Der Auslösekontakt 3 ist mit der Gleichspannungsquelle 4 verbunden.

Beim Schließen des Auslösekontaktes 3 und zunächst geschlossenem Abschaltkontakt 1 wird die Auslösespule 2 erregt, so daß der Schaltprozeß vorgenommen wird. Um eine Überlastung der Auslösespule zu verhinden, öffnet nach Abschalten des Leistungsschalters der Abschaltkontakt 1 und unterbricht den Stromkreis.

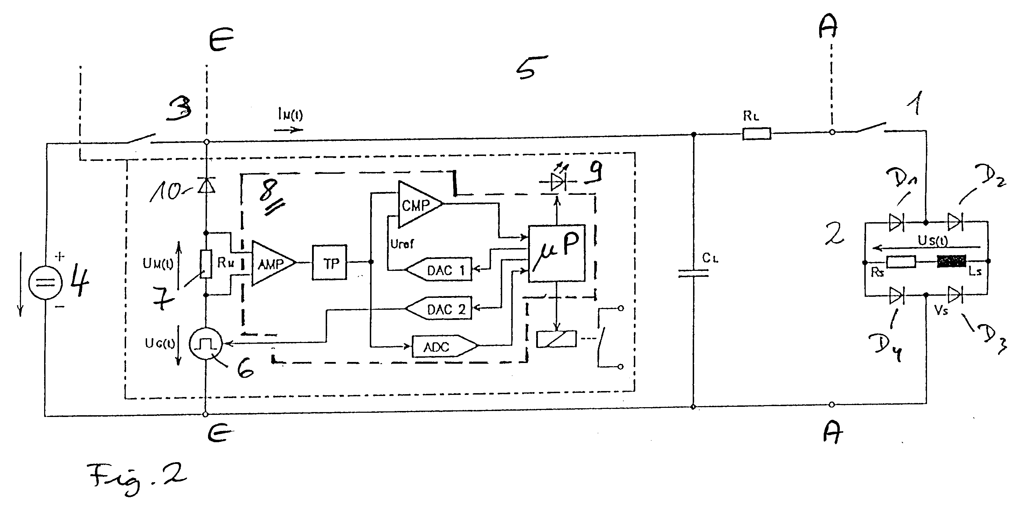

Die in Fig.2 dargestellte erfindungsgemäße Einrichtung zur Überwachung eines Leistungsschalters in Mitteloder Hochspannungsschaltanlagen unterscheidet sich von dem in Fig. 1 dargestellten Prinzipschaltbild dadurch, daß parallel zu den Eingangsklemmdn E der.Zuleitung 5 eine Impulsgeber- und analyseschaltung vorgesehen ist, bestehend aus einer Reihenschaltung aus einem Impulsgenerator 6 und einer Meßimpedanz 7, die hier als Meßwiderstand RM dargestellt ist. Als weiteres Element in der Reihenschaltung kann eine Schutzdiode 10 vorgesehen sein.

Parallel zu den Klemmen der Meßimpedanz 7 ist ein Meßverstärker AMP vorgesehen, der das Meßsignal verstärkt und auf einen Tiefpaß TP zur Filterung ausgibt. Das tiefpaßgefilterte Signal wird einerseits über einen Analog-Digitalwandler dem Mikroprozessor $\mu$ P zugeführt und andererseits einer Vergleicherschaltung CMP. Die Vergleicherschaltung erhält an ihrem anderen Eingang eine Referenzspannung, die über einen ersten Digital-Analogwandler DACI ebenfalls dem Mikroprozessor $\mu$ P entnommen wird. Der Mikroprozessor $\mu$ P analysiert den zeitlichen Verlauf der Spannung, die über dem Meßwiderstand 7 abfällt. Der elektrische Zustand des Auslösekreises wird durch Leuchtanzeigen 9 in der Frontplatte des Gerätes signalisiert. Für die Meldung von Gerätefehlern und Fehlern im überwachten Auslösekreis stehen getrennte Meldekontakte 11 zur Verfügung. Das Gerät ist mit einer galvanischen getrennten Schnittstelle für den Anschluß eines PCs ausgerüstet. Sie dient z.B. zur Parametierung und Ausgabe von Meßdaten.

Darüber hinaus verfügt die Einrichtung über eine im folgenden beschriebene Selbstadaptierung des Gerätes an den Auslösekreis:
Zunächst ermittelt das Gerät die Sprungantwort und die elektrischen Kennwerte des fehlerfreien Auslösekreises. Diese Kennwerte werden als Referenzwerte abgespeichert. Aus diesen Referenzwerten wird ein Meßimpuls für den Pulsgenerator 6 nach Amplitude und Periodendauer berechnet, der auf den jeweiligen Auslösekreis zugeschnitten ist. Die Ermittlung von Amplitude und Dauer des Meßimpulses geschieht dabei wie folgt:
Zunächst wird der Meßstrom so vorgewählt, daß er zwar ausreicht, um ein Meßsignal zu erhalten, jedoch sicher unterhalb der Schwelle liegt, die den Leistungsschalter unbeabsichtigt auslösen würde. Dann wird die Generatorspannung von 0 V ansteigend langsam erhöht, bis sich im Auslösekreis der vorgewählte Meßstrom einstellt. Diese Amplitude des Meßimpulses wird abgespeichert. Anschließend wird die Generatorspannung auf den Meßkreis (Generator, Meßwiderstand, Auslösekreis) aufgeschaltet und diejenige Zeitdauer, z.B. mittels eines Timers, gemessen, bis zu der der Meßstrom auf das 0,63-fache seines Endwertes angestiegen ist. Das 10-fache dieser "Zeitkonstanten" des Meßkreises wird als Meßimpulsdauer festgelegt und ebenfalls abgespeichert.

Bei einem Wechsel des Auslösekreises wiederholt sich der Vorgang, so daß für diesen geeignete Daten des Meßimpulses ermittelt werden. Auf diese Weise wird eine automatische Anpassung des Gerätes an den zu überwachenden Auslösekreis erreicht.

Das Gerät ist mit einer Selbstüberwachung des μ P ausgerüstet.

Über den Mikroprozessor μ P wird auch die Periodendauer des Pulsgenerators 6 derart geregelt, daß diese klein ist gegenüber der Erregungszeit des Auslösekreises.

Desweiteren sind in Fig. 2 dargestellt Ersatzschaltbildelemente wie Leitungskapazität CL und dem Leitungswiderstand RL. Rechts in der Figur ist das Ersatzschaltbild der Auslösespule dargestellt, die aus der Induktivität LS und dem Ohm'schen Anteil RS besteht. Die Reihenschaltung aus dem Ohm'schen Anteil und dem induktiven Anteil RS und LS bildet den Mittelzweig einer Brückengleichrichterschaltung, deren Brückendiagonalen durch die Dioden DI, D2,D3,D4 gebildet sind und eine Schutzbeschaltung für die Auslösespule darstellen.

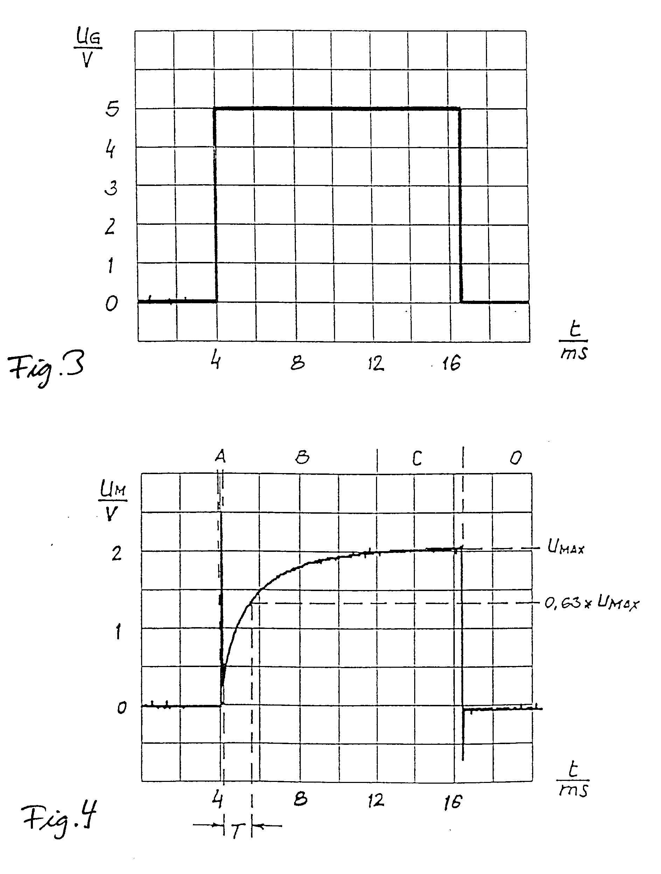

Die Funktion der erfindungsgemäßen Vorrichtung bzw. die Wirkungsweise des Verfahrens wird im folgenden anhand der in den Figuren 3 - 7 dargestellten Impulsdiagramme näher erläutert.

Figur 3 zeigt das Ausgangssignal des Pulsgenerators 6 in Form eines Rechteckimpulses mit einer Amplitude von 5 Volt und einer Periodendauer von 12,5 Millisekunden.

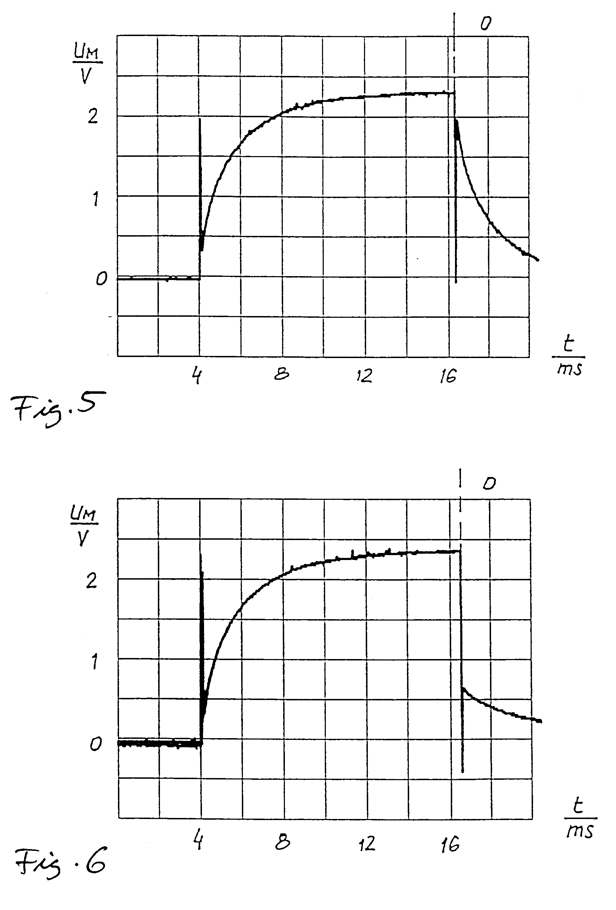

Die Figuren 4 - 7 zeigen jeweils die am Meßwiderstand RM gemessenen Spannungsabfälle UM (T), und zwar bei unterschiedlichen Beschaltungsbedingungen.

So zeigt Fig.4 eine typische Sprungantwort eines Auslösekreises, welcher sich in verschiedene zeitliche Bereiche A-D gliedern läßt.

Der Zeitbereich A ist bedingt durch die Auswirkungen der Leitungskapazität CL. Diese bestimmt die Steilheit des Spannungsstoßes zum Zeitpunkt des Spannungssprunges in Fig. 3.

Der nachfolgende Zeitbereich B ist bedingt durch die Spuleninduktivität LS. Aus der Zeitkonstanten T, d.h. der Zeitspanne, die bis zum Anstieg der Spannung auf das 0,63-fache der Maximalspannung vergeht, läßt sich die Induktivität des Auslösekreises nach der Formel $T = L/RGES$ ausrechnen.

Der Bereich C, d.h. der stationäre Zustand, ist bedingt durch den Ohm'schen Widerstand des Meßkreises, d.h. durch die Summe der Widerstände RM, RL und RS, wobei sich der Gesamtwiderstand des Auslösekreises errechnet zu:

$$RGES = UG/Umax \ (RM).$$

Weichen nun die gemessenen zeitlichen Verläufe von Referenzverläufen ab, kann aus dem Verlauf in den jeweiligen Zeitbereichen A,B,C,D auf Fehler geschlossen werden. Wenn z.B. bei Übereinstimmung in Bereich A und Erreichen des vorgegebenen Spannungswertes Umax im Bereich C die im Bereich B vorliegende Zeitkonstante T vom Sollwert abweicht, deutet dies auf eine Veränderung der Spuleninduktivität hin, die möglicherweise durch Windungsschlüsse bedingt ist.

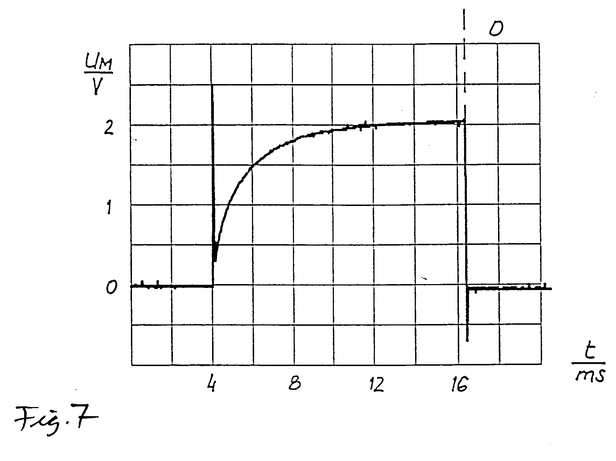

Unter Anwendung des erfindungsgemäßen Verfahrens läßt sich nicht nur in den Bereichen A-C, wie bisher beschrieben, eine Fehlerdiagnose durchführen, sondern auch durch die Auswertung des Bereichs D. Dieser Bereich hängt von Art und Funktion der Schutzbeschaltung der Auslösespule ab. So zeigt beispielsweise Fig.5 eine Sprungantwort eines Auslösekreises ohne Schutzbeschaltung. Man erkennt im Bereich D nach dem Umladen der Leitungskapazität deutlich das vollständige Entladen der Spule aufgrund der Spulenverluste und den Meßkreis.

Fig. 6 entspricht demgegenüber einem Auslösekreis mit einer Schutzbeschaltung aus einer Kombination Diode-Widerstand. Hierbei wird die Spulenenergie anfangs von der Schutzbeschaltung und nach Sperren der Diode vom Meßkreis absorbiert.

Fig. 7 schließlich zeigt die Sprungantwort eines Auslösekreises, in dem die Auslösespule in einer Brückengleichrichterschaltung angeordnet ist. Hierbei gelangt nach dem Abschalten des Meßimpulses praktisch keine Energie der Auslösespule mehr in den Meßkreis.

**Patentansprüche**

1. Einrichtung zur Überwachung eines Auslösekreises eines elektrischen Betriebsmittels, insbesondere eines Leistungsschalters in Mittel- oder Hochspannungsschaltanlagen, dessen Auslösespule (2) über eine Zuleitung (5) mit entfernt angeordneten Auslösekontakten (3) verbunden ist, auf elektrische Defekte,
**dadurch gekennzeichnet**, daß parallel zu den Eingangsklemmen (E) der Zuleitung (5) eine Reihenschaltung aus einem einen Spannungssprung erzeugenden Generator (6) und einer Meßimpedanz (7) angeordnet ist und daß Mittel (8) zur Erfassung des zeitlichen Verlaufs des Spannungsabfalls an der Meßimpedanz (7) sowie für dessen Unterteilung in zeitdiskrete Bereiche (A,B,C,D) und für dessen bereichsbezogene Analyse vorgesehen sind.

2. Einrichtung nach Anspruch 1,
**dadurch gekennzeichnet**, daß das von der Meßschaltung (8) erfaßte Meßsignal einer Vergleichereinrichtung zugeführt wird, die die von der Meßschaltung (8) erfaßten zeitlichen Verläufe des Spannungsabfalls mit dem zeitlichen Verlauf des Spannungsabfalls im fehlerfreien Betrieb vergleicht.

3. Einrichtung nach Anspruch 1 oder 2,
   **dadurch gekennzeichnet**, daß die Auslösespule (2) des Leistungsschalters in Reihe mit einem Abschaltkontakt (1) am Zuleitungsausgang (A) angeschlossen ist.

4. Einrichtung nach einem der vorhergehenden Ansprüche,
   **dadurch gekennzeichnet**, daß die Auslösespule (2) des Leistungsschalters eine Schutzbeschaltung aufweist.

5. Einrichtung nach einem der vorhergehenden Ansprüche,
   **dadurch gekennzeichnet**, daß die Meßschaltung (8) einen Meßverstärker (AMP), einen Tiefpaß (TP) und einen Analog-Digitalwandler (ADC) aufweist zur Aufbereitung des Meßsignals und zu seiner Verarbeitung in einem Mikroprozessor ($\mu$ P).

6. Einrichtung nach Anspruch 5,
   **dadurch gekennzeichnet**, daß die Meßschaltung (8) einen ersten Digital-Analogwandler (DACI) aufweist, der ein Referenzsignal des Mikroprozessors ($\mu$ P) auf einen Vergleicher (CMP) gibt zum Vergleich mit dem tiefpaßgefilterten Meßsignal.

7. Einrichtung nach einem der vorhergehenden Ansprüche,
   **dadurch gekennzeichnet**, daß der Generator ein Pulsgenerator ist und daß die Meßschaltung (8) einen zweiten Digital-Analogwandler (DAC2) aufweist, durch dessen Ausgangssignal die Pulsbreite und/oder Amplitude des Pulsgenerators (6) einstellbar ist.

8. Einrichtung nach einem der vorhergehenden Ansprüche,
   **dadurch gekennzeichnet**, daß die Meßschaltung (8) Mittel zu ihrer Selbstadaptierung an den zu überwachenden Auslösekreis aufweist, derart, daß die Mittel die Sprungantwort und die elektrischen Kenngrößen des fehlerfreien Auslösekreises erfassen, und hieraus berechnete Referenzwerte abspeichern, aus denen Amplitude und Periodendauer des Meßimpulses des Pulsgenerators (6) ermittelt werden.

9. Einrichtung nach einem der vorhergehenden Ansprüche,

**dadurch gekennzeichnet**, daß die Meßschaltung (8) eine galvanisch getrennte Schnittstelle für den Anschluß eines Personalcomputers aufweist.

10. Verfahren zur Überwachung eines Auslösekreises eines elektrischen Betriebsmittels, insbesondere eines Leistungsschalters in Mittel- oder Hochspannungsschaltanlagen, dessen Auslösespule (2) mit dem Auslösesignal eines über eine Zuleitung entfernt angeordneten Auslösekontaktes (3) beaufschlagt wird, auf elektrische Defekte,
    **dadurch gekennzeichnet**, daß die Sprungantwort des Auslösekreises (5,1,2) auf einen an den Leitungseingang (E) angelegten Spannungssprung detektiert wird, daß der zeitliche Verlauf der Sprungantwort in zeitdiskrete Bereiche aufgeteilt wird und daß bereichsbezogen ein Vergleich der Sprungantwort mit der beim fehlerfreien Betrieb ermittelten Sprungantwort erfolgt.

Fig. 1

Fig. 2

EP 0 638 812 A2

Fig. 3

Fig. 4

Fig. 5

Fig. 6

Fig. 7